# EUROPEAN PATENT SPECIFICATION

(11) **EP 4 060 614 B1**
(45) Date of publication and mention of the grant of the patent: **10.09.2025**
(21) Application number: 21163577.6
(22) Date of filing: 19.03.2021
(51) Int. Cl.: G06T 7/277

(54) **METHOD FOR DETERMINING NOISE STATISTICS OF OBJECT SENSORS**
VERFAHREN ZUR BESTIMMUNG DER RAUSCHSTATISTIK VON OBJEKTSENSOREN
PROCÉDÉ DE DÉTERMINATION DES STATISTIQUES DE BRUIT DES CAPTEURS D'OBJETS

(43) Date of publication of application: 21.09.2022
(73) Proprietor: Aptiv Technologies AG, 8200 Schaffhausen (CH)
(72) Inventor: MAOZ, Ori, 51427 Bergisch Gladbach (DE); GEBHARDT, Patrik, 58332 Schwelm (DE)
(74) Representative: Lewis Silkin LLP

(56) References cited:
- WO-A1-2019/179882
- TAK KIT LAU ET AL: "Inertial-Based Localization for Unmanned Helicopters Against GNSS Outage", IEEE TRANSACTIONS ON AEROSPACE AND ELECTRONIC SYSTEMS, IEEE SERVICE CENTER, PISCATAWAY, NJ, US, vol. 49, no. 3, 1 July 2013 (2013-07-01), pages 1932 - 1949, XP011519675, ISSN: 0018-9251, DOI: 10.1109/TAES.2013.6558029
- CHEN ZHAOZHONG ET AL: "Weak in the NEES?: Auto-Tuning Kalman Filters with Bayesian Optimization", 2018 21ST INTERNATIONAL CONFERENCE ON INFORMATION FUSION (FUSION), ISIF, 10 July 2018 (2018-07-10), pages 1072 - 1079, XP033397753, DOI: 10.23919/ICIF.2018.8454982
- GOODALL CHRIS ET AL: "Intelligent Tuning of a Kalman Filter for INS/GPS Navigation Applications", GNSS 2007 - PROCEEDINGS OF THE 20TH INTERNATIONAL TECHNICAL MEETING OF THE SATELLITE DIVISION OF THE INSTITUTE OF NAVIGATION (ION GNSS 2007), THE INSTITUTE OF NAVIGATION, 8551 RIXLEW LANE SUITE 360 MANASSAS, VA 20109, USA, 28 September 2007 (2007-09-28), pages 2121 - 2128, XP056010348

## Description

### TECHNICAL FIELD

The present disclosure relates to the field of trackers which are typically used for pattern recognition, e.g. in the automotive sector, and to each of which at least one object detector or sensor is connected for providing noisy observation data. The tracker of the present disclosure is provided with a Kalman filter to improve tracking of a time-varying object across a scene. Based on such equipment, the present disclosure makes use of high-quality reference data in order to automatically collect error or noise statistics of at least one sensor and use the statistics to calibrate the Kalman filter of the tracker.

More specifically, the present disclosure relates to a method for automatically determining and using such noise statistics, as well as a non-transitory computer-readable medium and a tracker for implementing the method.

### BACKGROUND

The document from TAK KIT LAU et al entitled "Inertial-Based localization for Unmanned Helicopters Against GNSS outage" discloses an algorithm using Kalman filters. The document from CHEN ZHAOZHONG et al entitled "Weak in the NEES? : Auto-Tuning Kalman Filters with Bayesian Optimization" discloses a Bayesian optimization strategy for tuning Kalman filters. Kalman filters are conventionally used in perception systems to provide, by predictions, stable (linear) tracking of objects across scenes based on observations from one or more sources. To this end, Kalman filters are implemented by an algorithm programmed in accordance to an internal model. In order to properly balance their internal model predictions with external observations, Kalman filters require estimates of the observation noise of each of the sources. These sources are typically constituted by sensors, such as object detectors, connected to the Kalman filter like peripheral devices. Large noise estimations would result in the tracker giving more credence to predictions issued from its own internal state, while low noise estimations would give more credence to the observations.

Noise estimations are usually the result of tuning and experimentation, and setting them is considered a form of "black art". Trackers based on Kalman filters must be manually tuned by experts, a process which is labour-intensive and error-prone. The tuning process must be repeated whenever the sensor or object detector are modified, further slowing down the development cycle and increasing the risk of introducing errors. Modern vehicles mount multiple sensors of each type, so the process must often be repeated for each of these.

Modern machine-learning-based object detectors often report a confidence value with each detected object, which correlates with how likely the detection is to be correct/accurate. These confidence values could be used by the tracker to give higher or lower credence to each detection, but there is currently no straightforward way to do this. Furthermore, while confidence values might be used to filter or reweight the outputs of a single detector, they are even more difficult to apply when combining the outputs of multiple detectors. This is because confidences reported by different object detectors do not necessarily lie in the same ranges or associate the same magnitude of errors to each value. Making confidences of multiple object detectors thus requires specifically designing the detectors to report comparable confidence value, reducing reusability of existing algorithms.

Accordingly, there is a need for improving existing disclosures in order to at least partially overcome the aforementioned issues and drawbacks, especially to simplify the calibration process of trackers and to improve reliability of object observations, especially when several sensors are used with the tracker.

### SUMMARY OF THE DISCLOSURE

To address such a concern, the present disclosure suggests an automatic way to derive noise calibration for Kalman-based object detectors. More specifically, it suggests a method for automatically determining and using noise statistics of noisy observation data provided by at least one sensor connected to a tracker, in order to improve tracking of a time-varying object across a scene using a Kalman algorithm. The Kalman algorithm allows to get an estimation of dynamic parameters of the object and providing a precision of the estimation from the noisy observation data and from a corrected previous estimation. The aforementioned method comprises:
- receiving reference data from a data source external to the Kalman algorithm and connected to the tracker,
- deriving, from said reference data, said noise statistics reflecting errors made by the sensor, and
- using said noise statistics as setting parameters of the Kalman algorithm.

The present disclosure allows for more accurate tracking of objects and improving tracker performances. In addition, it further allows for fusing multiple detectors as 'black boxes' without assumptions on their internal function if the tracker comprises several sensors, i.e. several detectors. In this manner it can be possible to allow confidence-based sensor fusion for off-the-shelf software components.

In one embodiment, the reference data relates to the scene from which the noisy observation data has been got through the sensor, and wherein deriving the noise statistics from the reference data is obtained by comparing said reference data with the noisy observation data provided by the sensor.

Preferably, reference data comprises annotated observation data received from the data source, and the reference data is used to calibrate the tracker.

According to one embodiment, noise statistics comprise a precision of the sensor which defines the probability that the noisy observation data is correct.

Preferably, the precision of the sensor is used to determine whether the related noisy observation data provided by said sensor is to be taken into account by the tracker for tracking said object or is to be discarded.

In one embodiment, the noisy observation data relates to a plurality of measured variables of the object from which at least one pair of measured variables is identifiable, and said noise statistics comprises at least one of:
- an expected variance of each of the measured variables, and
- an expected covariance between each pair of measured variables.

Preferably, the measured variables relate to at least one of:
- dimensional data of the object,
- positioning data of the object within the scene,
- distance data between the object and the sensor,
- an absolute or relative speed data of the object, and
- an absolute or relative acceleration data of the object.

According to a preferred embodiment, the expected covariance between each pair of measured variables is provided in a covariance matrix or vector form and is used as an input of the Kalman algorithm for defining an observation noise of the noisy observation data.

In one embodiment, the sensor reports a confidence value which is in relationship with a probability that noisy observation data is correct or accurate, and the method further comprises:
- using said confidence value as weighting parameter applied to said noisy observation data via an observation noise further inputted in the Kalman algorithm.

In a further embodiment, the sensor reports a confidence value which is in relationship with a probability that noisy observation data is correct or accurate, and the method further comprises:
- comparing said confidence value to a plurality of predetermined confidence intervals to each of which an error parameter is associated, and
- including in said noise statistics the error parameter associated to the confidence interval which comprises the confidence value.

Preferably, the error parameter is determined during a preprocessing phase aiming to:
- run the sensor over a set of reference data to collect a plurality of confidence values,
- separate said reference data into subsets depending on said confidence values,
- compare, for each subset, the noisy observation data provided by the sensor with the related reference data, and
- compute an error covariance and the precision of the sensor as data forming said error parameter.

According to one embodiment, the sensor reports a confidence value quantifying a probability that noisy observation data is correct or accurate, and the method further comprises:
- using a regression model, which establishes a relationship between an error and the confidence value for determining the error corresponding to the reported confidence value,
- including in said noise statistics the error provided by the regression model for the reported confidence value.

Preferably, the regression model is determined on the basis of a scatter pot obtained from a plurality of detections of the object by the sensor, wherein each point of the scatter plot is derived from a confidence value and an error determined at each detection

The present disclosure further relates to a non-transitory computer-readable medium comprising program instructions for causing a processor to execute the method according to any of the method embodiment or according to any possible combination of its embodiments.

The present disclosure also relates to a tracker for implementing the aforementioned method according to any of its embodiments or according to any possible combination of its embodiments, said tracker comprising:
- a processing unit for storing and running the Kalman algorithm and steps of the method,
- a first communication interface for connecting at least one sensor providing noisy observation data, and
- a second communication interface for receiving reference data from an external data source.

Other embodiments and advantages will be disclosed hereafter in the detailed description.

### BRIEF DESCRIPTION OF THE DRAWINGS

The disclosure and the embodiments suggested in the present disclosure should be taken as non-limitative examples and will be better understood with reference to the attached Figures in which :
Fig. 1 is a schematic representation of main entities of a environment including a tracker suitable for implementing the method of the present disclosure,
Fig. 2 is a schematic representation of a Kalman filter,
Fig. 3 shows an explanatory diagram helping the understanding of the notion of precision within a statistics approach,
Fig. 4 is a schematic representation of comparisons between example outputs of an object sensor and reference data to collect statistics of the errors made by the sensor,
Fig. 5 is a schematic representation of a partition of confidence value ranges to each of which an error parameter is assigned,
Fig. 6 is a schematic diagram of using noise statistics as setting parameter of the Kalman algorithm depending on the confidence value reported by the sensor, and
Fig. 7 is a schematic diagram showing fusing detections from multiple sources.

### DETAILED DESCRIPTION

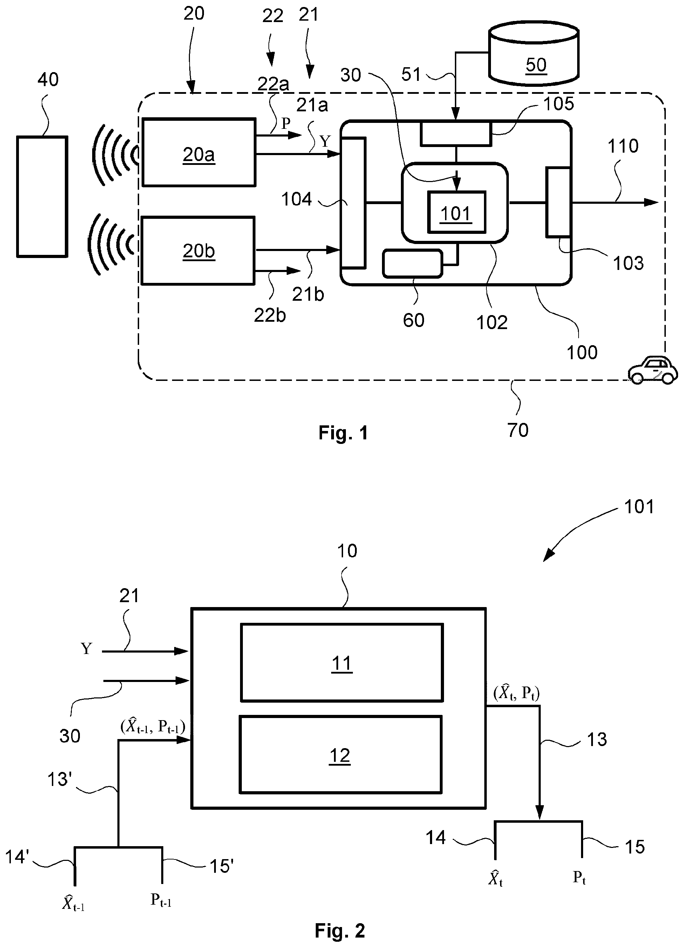

Fig. 1 shows a schematic illustration of an environment including a tracker 100 suitable for implementing the method of the present disclosure. The aforementioned environment further includes other main entities such as sensors 20 as well as an object 40 of a scene tracked by the tracker 100 through the sensors 20. Although two sensors 20a, 20b are shown as example in Fig. 1, it should be understood that the number of sensors 20 are not limited to two so that the tracker 100 may comprise or be connected to at least one sensor 20. The sensors 20 may be any kind of sensor or object detector and typically operate using a radar detection technology. Accordingly, these sensors are based on electromagnetic or sound waves, such as radio, ultrasounds, infrared or laser waves for example. The object 40 of the scene may typically be an object within a road environment, for example an obstacle or a road user. The sensors 20 and the tracker 100 are preferably indented to be mounted on a vehicle, such as a smart or autonomous vehicle, to get an on-road environment perception.

As schematically shown in Fig. 1, the tracker 100 includes a processor or processing unit 102 for storing and running a Kalman algorithm that may act or be regarded as a Kalman filter 101. The tracker 100 further includes at least a first communication interface 104 for connecting at least one sensor 20, and preferably a second communication interface 105 for connecting the tracker 100 to a data source 50 which may be an external data source 50. Tracking data 110, providing the estimate state of the object 40, is outputs from the tracker 100, e.g. through a third communication interface 103.

Fig. 2 provides a schematic illustration of a Kalman filter 101. The Kalman filter 101 may be regarded as a device hosting a mathematical tool that is usually implemented through an algorithm 10 for estimating the state of a dynamic system from generally partial and noisy observations. The dynamic system may typically be the movement of the object 40 within a scene. To this end, the filter 101, more specifically the Kalman algorithm 10, takes as input a sequence of observation data 21 such that each observation is linearly linked to a precise unknown state. The purpose of the algorithm 10 is to estimate these states in an optimal and recursive way. The power of the Kalman filter 101 is its ability to predict parameters and correct errors, not only for the sensors 20 which act as observation data sources, but also of the model itself. Accordingly, the Kalman filter 101 is able to integrate an imprecision term on the model itself, which allows the filter 101 to give correct estimates despite reasonable modeling errors.

Without going into details, the Kalman algorithm 10 is based on a two-step process as schematically depicted in Fig. 2. The first step is a prediction step 11 which predicts the state of the system, more specifically the dynamic parameters of the observed object 40. The second step is an update step 12 that uses the noisy observation data 21, namely error-prone measurements Y provided by the sensor(s) 20 on the observed object 40, in order to refine the estimate of the system state. Since each of the sensors 20a, 20b provides noisy observations, the noisy observation data 21 issued by the first sensor 20a is identified by the reference numeral 21a and that issued by the second sensor 20b is identified by the reference numeral 21b in Fig. 1.

At its output, the Kalman algorithm 10 provides output data 13 regarding the observed object, in particular dynamic parameters defining the object 40 or related to it at an instant t. The output data 13 includes an estimation 14 and a precision 15 of the estimation 14. In Fig. 2, the output data 13 is also identified by the literal values (*X̂*ₜ, Pₜ) where *X̂*ₜ is the estimation, more particularly the state vector comprising estimated parameters, and Pₜ is the precision of the estimation, typically an error covariance matrix.

The Kalman algorithm 10 further takes as input a corrected previous estimation 13' at the instant t-1. Accordingly, the corrected previous estimation 13' is also identified in Fig. 2 by the literal values (*X̂*ₜ₋₁, Pₜ₋₁), where *X̂*ₜ₋₁ is the previous estimation and Pₜ₋₁ is the previous precision of the estimation.

Modern machine-learning-based object sensors, most notably neural networks, often report a confidence value 22 with each detected object 40. The confidence value 22, especially each confidence value 22a, 22b reported by each of the sensors 20a, 20b (Fig. 1), correlates with how likely the detection is to be correct/accurate. Accordingly, it may be regarded as a precision P of the observation Y, as stated in Fig. 1.

It should be noted that the term precision is used here in accordance with its definition from statistics view. Accordingly, the precision is to be regarded as being the fraction of relevant instances among the retrieved instances. In other words, it is the probability that the observation issued from the sensor 20 is correct. There are two possible outcomes regarding the output issued by a sensor 20 from measures applied onto an object 40. Either the observations output from the sensor 20 includes some errors, e.g. regarding the location or the dimensions of the detected object 40, or the sensor 20 has detected a false object, since no object 40 exists in real in the scene. In the first case, the wording "true positive" is used, while in the second case the wording "false positive" is used.

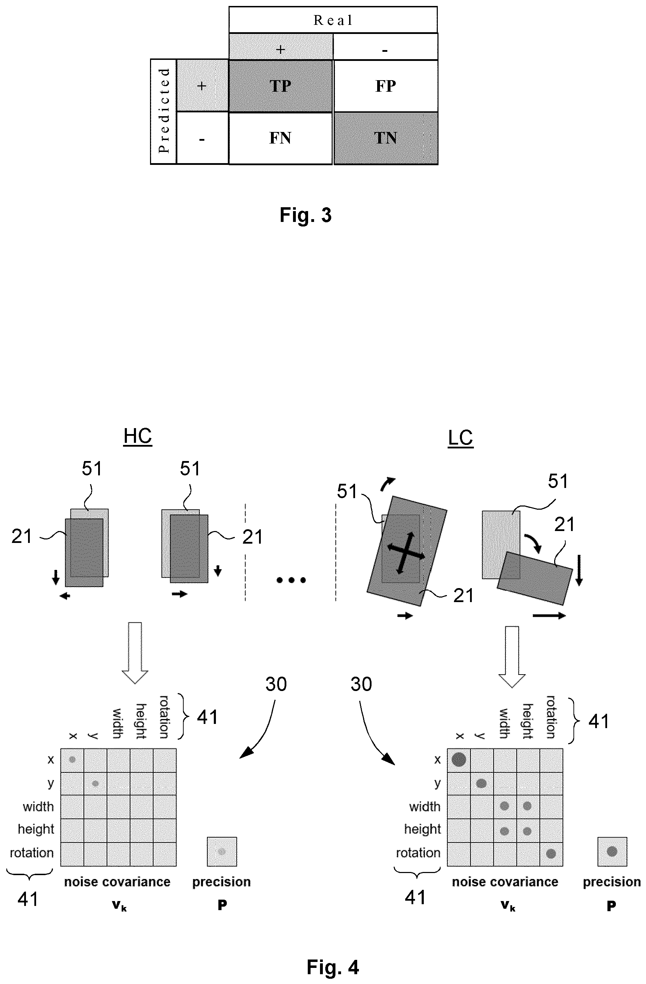

The concept of "false positive" and "false negative" is also shown in connection with Fig. 3. For example, a model is used to predict whether a driver will stop or continue at a light. Such a scenario is a binary classification for which the answers may be true or false. If the model has to predict the positive as the driver stops and the negative as the driver continues, then the "false positive" predicts that the driver stops whereas in real the driver continues. The "false negative" works in a reverse way, so that in such a case the model predicts that the driver will continue (negative) whereas the driver stops in real.

From the foregoing, the precision may be regarded as being the ratio of "true positives" to the total of "true positives" and "false positives". In other words, if the "true positives" are noted TP and the "false positives" are noted FP, as shown in the example of Fig. 3, therefore the precision P may be defined by the following expression : P = TP / (TP + FP).

In the Kalman filter shown in Fig. 2, the errors corresponding to the case of a "true positive", i.e. the errors regarding the dynamic or object parameters of object 40, would typically be described through the noise covariance matrix. On the other hand, if these errors relate to a "false positive", i.e. the detection of an non-existent object, they would typically be described by the precision P=TP/(TP+FP). Indeed, in that case, it is not meaningful to determine the error e.g. in location or in dimension of the object 40, given that there is no "true" object.

In its main approach, the method of the present disclosure will be described on the basis of Figs. 1 and 2. It relates to a method for automatically determining and using noise statistics 30 of noisy observation data 21 provided by at least one sensor 20 connected to a tracker 100, in order to improve tracking of a time-varying object 40 across a scene using a Kalman algorithm 10. The Kalman algorithm allows to get an estimation 14 of dynamic parameters of the object 40 and providing a precision 15 of the estimation 14 from said noisy observation data 21 and from a corrected previous estimation 13'. The method includes the following steps:
- receiving reference data 51 from a data source 50 external to the Kalman algorithm 10 and connected to the tracker 100,
- deriving, from said reference data 51, the noise statistics 30 reflecting errors made by the sensor 20, and
- using the noise statistics 30 as setting parameters of the Kalman algorithm 10.

It should be noted that the reference data 51 can typically be received at the tracker 100, e.g. via the second communication interface 105, and that deriving and using the noise statistics 30 can be carried out by the tracker 100, in particular by the processing unit 102, e.g. by the Kalman filter 101 which may considered as being part of the processing unit 102. It should be also pointed out that the noise statistics 30 should not be confused with the confidence value 22 reported by the sensor 20. Indeed, the confidence value 22 relates to data output by the sensor, as shown in Fig. 1, whereas the noise statistics 30 relates to data that may typically provided by the tracker 100, more specifically by its processing unit 102 which preferably includes the Kalman filter 101. In that case, since the noise statistics 30 is provided by the processing unit 102 in order to be input as setting parameters of the Kalman algorithm 10, the noise statistics 30 can be regarded as setting parameters determined and used within the processing unit 102.

The data source 50, from which reference data 51 is provided, is typically an external data source 50, in particular a data source external to the Kalman algorithm 10, so that the reference data does not comes from the Kalman algorithm 10. Accordingly, the data source 50 is external to the Kalman filter 101 and preferably external to the processing unit 102. Still preferably, the data source is external to the tracker 100. Therefore, the tracker 100 may typically be connected to the data source 50, e.g. via a wired or wireless connection through the second communication interface 105. In a preferred embodiment, the data source 50 is a remote database or server to which the tracker 100 can connect e.g. via a wide area network such as the Internet.

Since noise statistics 30 both reflect errors made by the sensor 20 and are derived from reference data 51, it means that reference data 51 can be regarded as ground truth data or data reflecting the absolute truth. The nature and/or format of the reference data 51 will preferably depends on the nature and/or format of the noisy observation data 21, so that both of them are of the same type and can be properly compared. Therefore and in accordance with a preferred embodiment, reference data relates to the scene from which the noisy observation data 21 has been got through the sensor 20. In other words, reference data 51 may be regarded as a description of the scene that is in the same domain as the inputs of the sensor 20 which are the noisy observation data 21. For example, if the sensor outputs data regarding a plurality of bounding boxes which may be each defined through several object parameters such as center, dimension and/or rotation, then the reference data 51 will also relate to a bounding boxes, in particular to the same parameters as the aforementioned object parameters.

Preferably, deriving the noise statistics 30 from the reference data 51 is obtained by comparing the reference data 51 with the noisy observation data 21 provided by the sensor 20. According to the above example, the noise statistics 30 may be computed by comparing the detected bounding boxes with respect to the reference bounding boxes.

Recently, the advert of machine learning for sensory perception has spurred a surge in collection and annotation of sensor data, used to train machine learning models. The annotated data offers a unique opportunity to automatically measure the error statistics 30 of object sensors 20 and use it, for example, to calibrate trackers 100. Accordingly, in one embodiment reference data 51 includes annotated observation data received from the data source 50. Annotated data, also referred to as "labeled data", relates to data in which the desired output is marked manually. For example, annotated data could be bounding boxes manually marked by a human around the objects in the scene. Accordingly, annotated data may typically be geometrical data (dimensions, distances, angles, segments, curves, coordinates, etc.). On occasion, annotated data relates to dynamical data (speeds, acceleration, etc.) or semantics data (words such as key words for example). Anyway, annotated data are very useful in machine learning methods, where data pairs (each comprising an observation and an annotation) are provided to the algorithm which seeks a mapping between the inputs and the desired output. Usually, the annotated data is in the same format as the noisy observation data 21 output from the sensor 20. The only difference may relate to the confidence value, which is typically omitted from the annotated data since they are treated as "absolute truth".

According to one embodiment, the present disclosure preferably makes use of the reference data 51, preferably high-quality reference data 51, in order to automatically calibrate the tracker 100. Such a calibration may be carried out in an automatic manner during an initialization phase or a so-called calibration phase.

Fig. 4 is a schematic representation of successive comparisons between example outputs of an object sensor 20 and reference data 51, in order to derive and collect therefrom statistics 30 of the errors made by the sensor 20. To this end, a sequence of such comparisons is schematically depicted at the top of Fig. 4, from its left side to its right side. The examples depicted on the left side show what it may be considered as high confidence detections with respect to low confidence detections shown in the examples depicted on the right side.

To perform such determinations, noisy observation data 21 are compared to reference data 51 which may typically refer to annotated data relating to the same scene as that on which the sensor 20 is used for capturing the noisy observation data 21. Such a scene may be used for validation purposes during the development of the sensor 20. As schematically shown in Fig. 4, the output provided by the sensor 20, namely the noisy observation data 21, is compared to the reference data 51 in order to derive and collect noise statistics 30 reflecting the errors made by the sensor.

The case where the detection made by the sensor 20 provides a high confidence HC is shown through two examples in which there is a slight offset between the noisy observation data 21 and the reference data 51. On the other hand, the right side of Fig. 4 shows low confidence LC detection through two other examples in which the noisy observation data 21 has both dimensioning and positioning defects in the first example, and a significant rotation defect in the second example.

As illustrated in Fig. 4, the noise statistics 30 may include the precision P of the sensor 20 which defines the probability that the noisy observation data 21 is correct, in particular the probability that a positive detection is correct. The precision can be determined by the formulation P = TP / (TP + FP) discussed in connection with Fig. 3.

Preferably, the precision P of the sensor 20 is used to determine whether the related noisy observation data 21 provided by the sensor 20 is to be taken into account by the tracker 100 for tracking the object 40 or is to be discarded.

According to one embodiment, noisy observation data 21 relates to a plurality of measured variables 41 of the object 40 from which at least one pair of measured variables 41 is identifiable, and the noise statistics 30 includes at least one of:
- an expected variance of each of the measured variables 41, and
- an expected covariance between each pair of measured variables 41.

Such an embodiment is illustrated in Fig. 4 in which the plurality of measured variables 41 relates, in the present example, to values or coordinates x, y, as well as to the width, the height and the rotation of the object 40. The values x, y may relate to the center of the object or to another specific point(s) such as the corners if the object is e.g. a rectangular box as depicted in Fig. 4.

According to a general approach, the measured variables 41 may relate to at least one of:
- dimensional data of the object 40,
- positioning data of the object 40 within the scene,
- distance data between the object 40 and the sensor 20,
- an absolute or relative speed data of the object 40, and
- an absolute or relative acceleration data of the object 40.

The variance refers to a measure of the dispersion of the values of the sample. It is determined relative to the mean of the measures values, in particular as being the mean of the squares of the deviations from the aforementioned mean. The covariance provides the degree of dependence between two variables, i.e. between a pair of measured variables 41. The noise covariance is the error covariance or in other words the precision of the estimation which may be represented through an error covariance matrix or a noise covariance matrix identified by vₖ in Fig. 4.

According to one embodiment, the expected covariance between each pair of measured variables 41 is provided in a covariance matrix vₖ or vector form and is used as an input of the Kalman algorithm 10 for defining an observation noise of the noisy observation data 21. In other words, the observation noise is a noise statistics 30 that can be used as setting parameter of the Kalman algorithm 10. As shown in Fig. 2, the observation noise or noise statistics 30 is inputted in the Kalman algorithm in addition to the noisy observation data 21 and the corrected previous estimation 13'.

According to another embodiment, the sensor 20 reports a confidence value 22, depicted in Fig. 1, which is in relationship with a probability that noisy observation data 21 is correct or accurate. In other words, the confidence value 22 depends on the aforementioned probability or may be regarded as indirectly reflecting the aforementioned probability, in the sense that higher confidence values will be associated with more accurate detections. In the present embodiment, the method further includes:
- using the confidence value 22 as weighting parameter applied to the noisy observation data 21 via the observation noise (i.e. the error of the noisy observation data 21); the observation noise being further inputted in the Kalman algorithm 10.

In this case, the confidence value 22 is used indirectly to weight the noisy observation data 21. Such an operation may be carried out by any routine within the processing unit 102 or eventually within the Kalman filter 101. Noisy observation data 21 with high confidence value 22 would cause a low noise estimation to be provided into the Kalman algorithm 10. Accordingly, the tracker 100, internally, would thus give higher weight to that detection, because the noise estimation is an important part of the decision on what weight it should give it.

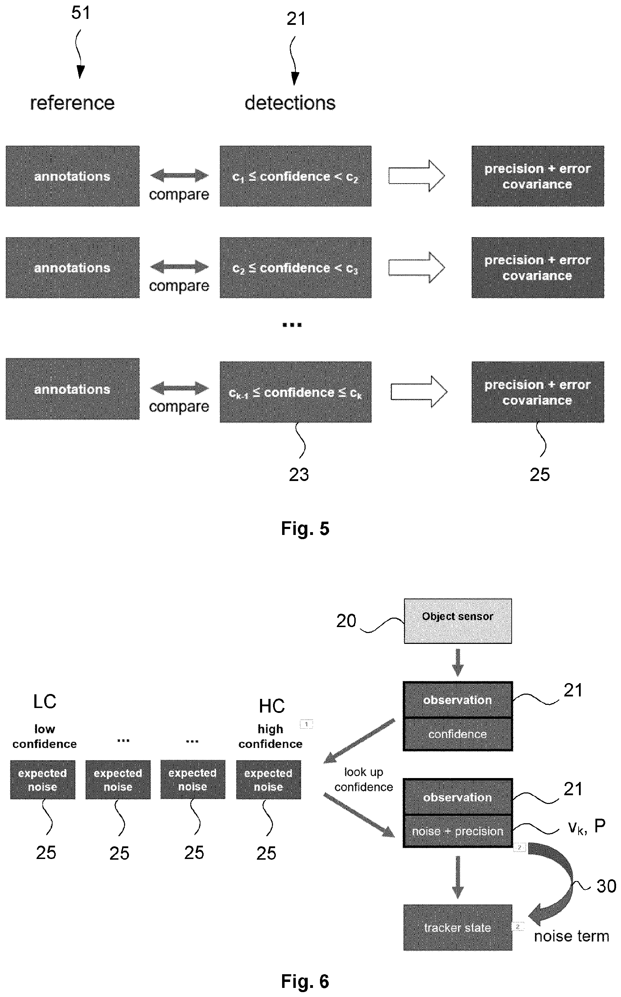

According to another embodiment schematically shown in Fig. 5, the sensor 20 reports a confidence value 22 which is in relationship with a probability that noisy observation data 21 is correct or accurate, and the method further includes:
- comparing the confidence value 22 to a plurality of predetermined confidence intervals 23 to each of which an error parameter 25 is associated, and
- including in said noise statistics 30 the error parameter 25 associated to the confidence interval 23 which includes the confidence value 22.

Again, such operations may be carried out by any routine within the processing unit 102 or eventually within the Kalman filter 101. Besides, from the aforementioned operations, it should be understood that the confidence 22 is assigned to one confidence interval 23 among a plurality of predetermined confidence intervals 23 which, in Fig. 5, are limited by the pairs of values {c₁, c₂}, {c₂, c₃}, ... {cₖ₋₁, cₖ} respectively assigned to the first interval, the second interval and the k^{th} interval.

Preferably, the error parameter 25 is determined during a preprocessing phase aiming to:
- run the sensor 20 over a set of reference data 51 to collect a plurality of confidence values 22,
- separate the reference data 51 into subsets depending on the confidence values 22,
- compare, for each subset, the noisy observation data 21 provided by the sensor 20 with the related reference data 51, and
- compute an error covariance and the precision of the sensor as data forming the error parameter 25.

Also, as mentioned earlier, such operations may be carried out by any routine within the processing unit 102 or eventually within the Kalman filter 101. The computed error covariance (noise covariance) is preferably made in the form of a matrix as shown in Fig. 4 through the reference vₖ. The preprocessing phase replaces the confidence value 22 provided by the sensor 20 for an observation with the noise estimated for that particular observation. It would allow for more accurate tracking of objects 40 and for fusing multiple sensors as 'black boxes' without assumptions on their internal function. In this manner, the tracker performances are improved while allowing confidence-based sensor fusion for off-the-shelf software components.

According to another embodiment, the sensor 20 reports a confidence value 22 quantifying a probability that noisy observation data 21 is correct or accurate, and the method further includes:
- using a regression model, which establishes a relationship between an error and the confidence value 22 for determining the error corresponding to the reported confidence value 22,
- including in the noise statistics 30 the error provided by the regression model for the reported confidence value 22.

As mentioned before, such operations may be carried out by any routine within the processing unit 102 or eventually within the Kalman filter 101. In addition, the aforementioned regression model can, for example, be used instead of a table providing a mapping between a first column providing the confidence values 22 and a second column providing the related errors that can be mapped to these confidence values 22. By using data of such a table, it could be also possible to get a scatter plot on a Cartesian graph wherein the values of the two columns may be reported on the two axis of the graph.

Accordingly, the regression model may be determined on the basis of a scatter plot obtained from a plurality of detections (i.e. noisy observation data 21) of the object 40 by the sensor 20, wherein each point of the scatter plot is derived from a confidence value 22 and an error determined at each detection.

As suggested in one embodiment, the noise statistics 30 may me regarded as confidence-dependent noise statistics if the confidence values 22 reported by the sensors 20 are used. These noise statistics 30, or confidence-dependent noise statistics, have two main applications when provided as inputs into a tracker 100, especially into the Kalman algorithm 10 of the tracker 100. The first application is to use the confidence values 22 to improve tracking performance of the Kalman tracker 100, and the second application is to use the confidence values 22 in order to fuse multiple sensors 20. Indeed, it is sometimes worthwhile to subdivide the covariance estimation across different axes. For example, an LIDAR-based object sensor 20 may accurately predict the orientation of an object 40, e.g. a vehicle, but such a sensor 20 may make much more mistakes on a pedestrian.

As first use case aiming to use confidence information for better tracking, Fig. 6 provides a schematic diagram of using statistics 30 as setting parameter of the Kalman algorithm 10 depending on the confidence value 22 reported by the sensor 20. Using the confidence value 22 in the tracker 100, allows the latter to assign higher credence to the more accurate predictions. Instead of calibrating the tracker, e.g. during an initialization or calibration phase, using a noise term based on the expected noise of the noisy observation data 21, the noise term may also be provided to the tracker 100 on a sample-by-sample basis. The confidence-dependent noise 30 can be used in a Kalman tracker 100 in several ways to obtain superior performances.

Indeed, as first way, the expected covariance matrix vₖ can be fed into the tracker 100 as an "observation noise covariance" parameter. The aforementioned parameter, when measured correctly, ensures that the tracker 100 optimally weights its internal state versus the external observations through the noisy observation data 21. The lower the predicted noise of a particular variable in an observation, the higher would the assigned weight of the observation be. In contrast to typical applications of Kalman filters in which all observations are assigned similar errors, or in which the errors each time are determined heuristically, in the present disclosure they are predicted separately for every detection based on actual measurements.

As a second way, the expected precision P can be used to determine whether the noisy observation data 21 should be incorporated into a track, especially into tracking data 110 output by the tracker 100. It can be determined on the basis of the maximum rate of false-positives FP that the tracker allows according to predefined setting parameters.

Thus, by providing a separate noise covariance matrix vₖ for each noisy observation data 21, we can naturally leverage the tracker 100 to use better or higher uncertainty estimates when incorporating the more uncertain detections, i.e. the more uncertain noisy observation data 21. These uncertainty estimates are also carried over into the track noise estimates maintained by the tracker 100, resulting in better decisions on when a track is no longer reliable. It should be noted that the noise covariance matrix vₖ may be obtained in an automatic manner during a calibration phase and thus require no manual tuning of parameters.

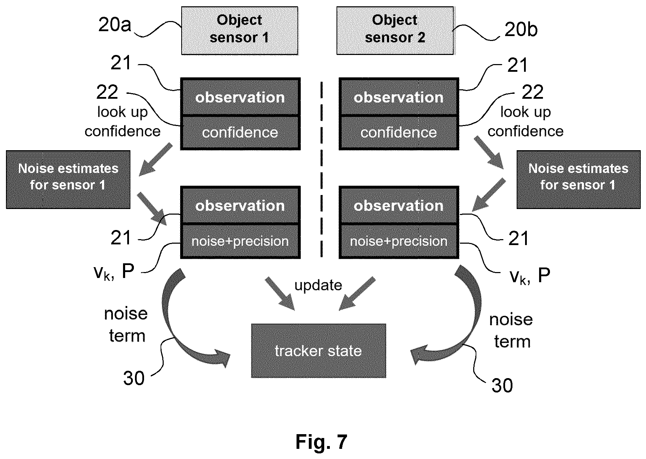

The second use case, mentioned above, aims to use confidence information for fusing multiple object sensors 20. Such a case is schematically illustrated through Fig. 7 which shows fusing detections from multiple sources, for example from the sensors 20a and 20b. Each of the sensors 20a, 20b includes its own detection method or process, so that different object detection processes will usually have different efficiencies or strengths. For example, one process may be more accurate in detecting long-distance objects, while another process may be better in separately detecting two objects which are close together.

Accordingly, fusing together the output of multiple processes, even when applied to the same noisy observation data 21, can provide superior performances. However, there is significant difficulties when trying to fuse the confidence values 22 provided by separate object detectors, such as the sensors 20a, 20b, since there is no standard way to report confidence values 22, and thus no reliable way to compare confidences of different sensors 20a, 20b. Indeed, differences in the reported confidence values 22 may include:
a) Confidences lying in completely different ranges.
b) Confidences lying in the same range, but are based on different scales. For example, a confidence value of 0.6 might denote a high confidence for the sensor 20a, whereas the same value (0.6) might denote a low confidence for the other sensor 20b.
c) The scales may also be exactly the same, but the sensors 20a, 20b themselves have different qualities of prediction. For example, a low-confidence observation provided by a "good" sensor 20 could be comparable to a high-confidence observation issued from a "bad" sensor 20.

Therefore, comparing confidence values 22 of multiple sensors 20 would require designing the sensors to output the same "type" of confidences. However, doing this would require careful engineering and would prohibit using off-the-shelf software components.

Advantageously, the present disclosure also efficiently solves the problem of comparing confidences of different sensors 20 by transforming the confidence values 22 issued by these sensors 20 into a conventional coordinate system that can easily be compared. Indeed, for each of the sensors 20, it is possible to determine the expected noise covariance (noise covariance matrix vₖ) and precision P of the sensor 20 in accordance with the previously disclosed embodiments. More specifically, the expected noise covariance vₖ and precision P can be determined as a function of the confidence value 22 of the related detector 20, based on its precomputed calibration data. Instead of using the confidence value 22 for assessing the noisy observation data 21, each observation (noisy observation data) is now associated with its expected precision P and expected noise covariance matrix vₖ, as schematically depicted in Fig. 7.

By replacing the confidence value 22 with a noise term (noise statistics 30) comprising the expected noise (noise covariance matrix vₖ) and precision P of the sensor 20, we transform something that only has meaning in the context of a single sensor 20 to something that has a universal meaning, especially a meaning for a plurality of sensors 20 and in particular a meaning for any sensor 20. As a result, the uncertainties reported by sensors 20 can be directly compared to each other, without requiring any modification to the sensors 20 themselves. Furthermore, the new values comprised in the noise statistics 30 have an interpretable "real world" meaning. Advantageously, this makes it much simpler to make design decisions and incorporate constraints, e.g. specify maximum tolerances on the predictions of specific variables of interest.

The present disclosure also relates to a non-transitory computer-readable medium 60 comprising program instructions for causing a processor, such as the processing unit 102 of Fig. 1, to execute the method according to any of its embodiments or according to any possible combination of its embodiments.

The term "non-transitory" does not exclude legitimate tangible temporary storage media such as flash drives or any rewritable storage media. Generally speaking, a computer-accessible medium may include any tangible or non-transitory storage media or memory media such as electronic, magnetic, or optical media. Such a media may be a disk, a CD/DVD-ROM or any other medium which may coupled to the processing unit 102, e.g. via a dedicated communication interface or one of the already disclosed communication interfaces, or which may located within another device (e.g. in a permanent manner), such as the processing unit 102 for instance.

The terms "tangible" and "non-transitory," as used herein, are intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer-readable medium" or "tangible memory" are intended to encompass types of storage devices that do not necessarily store information permanently, including for example, random access memory (RAM) and flash memory. Program instructions and data stored on a tangible computer-accessible storage medium in non-transitory form may further be transmitted by transmission media or signals such as electrical, electromagnetic, or digital signals.

The present disclosure further relates to a tracker 100 for implementing the aforementioned method according to any of its embodiments or according to any possible combination of its embodiments. As shown in Fig. 1, the tracker 100 includes:
- a processing unit 102 for storing and running the Kalman algorithm 10 and steps of the method,
- a first communication interface 104 for connecting at least one sensor 20 providing noisy observation data 21, and
- a second communication interface 105 for receiving reference data 51 from an external data source 50.

The aforementioned steps of the method encompass all the required steps to carry out any embodiment of the method or any possible combination of its embodiments. The estimate state of the object 40 is provided through the tracking data 110 outputs by the tracker 100, e.g. via a third communication interface 103. It should be noted that the number of communication interfaces may be different, for example a single communication interface may replace several communication interfaces, especially among the communication interfaces 103, 104, 105. Furthermore, the processing unit 102 may comprise the Kalman filter 101, as depicted in Fig. 1, or may be connected to the Kalman filter 101 if the latter is located outside the processing unit 102. The Kalman filter 101 includes the Kalman algorithm 10 and could also directly refer to the processing unit 102.

Finally, the present disclosure also relates to vehicle 70, preferably to a motor vehicle 70, comprising at least the aforementioned tracker 100, as schematically depicted in Fig. 1. Since the data source 50 is preferably an external or remote data source, it is preferably not part of the tracker 100 or the vehicle 70.

Although an overview of the inventive subject matter has been described with reference to specific example embodiments, various modifications and changes may be made to these embodiments without departing from the scope of embodiments of the disclosure disclosed in the present description.

## Claims

1. A method for automatically determining and using noise statistics (30) of noisy observation data (21) provided by at least one sensor (20) connected to a tracker (100), in order to improve tracking of a time-varying object (40) across a scene using a Kalman algorithm (10), said Kalman algorithm (10) allowing to get an estimation (14) of dynamic parameters of the object (40) and providing a precision (15) of said estimation (14) from said noisy observation data (21) and from a corrected previous estimation (13'), the method comprising:
- receiving reference data (51) from a data source (50) external to the Kalman algorithm (10) and connected to the tracker (100),
- deriving, from said reference data (51), said noise statistics (30) reflecting errors made by the sensor (20), and
- using said noise statistics (30) as setting parameters of the Kalman algorithm (10), the method being **characterized**
**by** said sensor (2) reporting a confidence value (22) which is in relationship with a probability that noisy observation data (21) is correct or accurate, and the method further comprises:
- using said confidence value (22) as weighting parameter applied to said noisy observation data (21) via an observation noise further inputted in the Kalman algorithm (10).

2. The method of claim 1, wherein said reference data (51) relates to the scene from which the noisy observation data (21) has been got through the sensor (20), and wherein deriving the noise statistics (30) from the reference data (51) is obtained by comparing said reference data (51) with the noisy observation data (21) provided by the sensor (20).

3. The method of claim 2, wherein said reference data (51) comprises annotated observation data received from the data source (50), and said reference data (51) is used to calibrate the tracker (100).

4. The method of any of claims 1 or 3, wherein said noise statistics (30) comprise a precision (P) of the sensor (20) which defines the probability that the noisy observation data (21) is correct.

5. The method of claim 4, wherein the precision (P) of the sensor (20) is used to determine whether the related noisy observation data (21) provided by said sensor (20) is to be taken into account by the tracker (100) for tracking said object (40) or is to be discarded.

6. The method of any of claims 1 to 5, wherein said noisy observation data (21) relates to a plurality of measured variables (41) of the object (40) from which at least one pair of measured variables (41) is identifiable, and said noise statistics (30) comprises at least one of:
- an expected variance of each of the measured variables (41), and
- an expected covariance between each pair of measured variables (41).

7. The method of claim 6, wherein the measured variables (41) relate to at least one of:
- dimensional data of the object (40),
- positioning data of the object (40) within the scene,
- distance data between the object (40) and the sensor (20), and
- an absolute or relative speed data of the object (40), and
- an absolute or relative acceleration data of the object (40).

8. The method of claim 6 or 7, wherein the expected covariance between each pair of measured variables (41) is provided in a covariance matrix (vₖ) or vector form and is used as an input of the Kalman algorithm (10) for defining an observation noise of the noisy observation data (21).

9. A method for automatically determining and using noise statistics (30) of noisy observation data (21) provided by at least one sensor (20) connected to a tracker (100), in order to improve tracking of a time-varying object (40) across a scene using a Kalman algorithm (10), said Kalman algorithm (10) allowing to get an estimation (14) of dynamic parameters of the object (40) and providing a precision (15) of said estimation (14) from said noisy observation data (21) and from a corrected previous estimation (13'), the method comprising:
- receiving reference data (51) from a data source (50) external to the Kalman algorithm (10) and connected to the tracker (100),
- deriving, from said reference data (51), said noise statistics (30) reflecting errors made by the sensor (20), and
- using said noise statistics (30) as setting parameters of the Kalman algorithm (10), the method being **characterized by**
said noise statistics (30) comprising a precision (P) of the sensor (20) which defines the probability that the noisy observation data (21) is correct, and
wherein said sensor (20) reports a confidence value (22) which is in relationship with a probability that noisy observation data (21) is correct or accurate, and the method further comprises:
- comparing said confidence value (22) to a plurality of predetermined confidence intervals (23) to each of which an error parameter (25) is associated, and
- including in said noise statistics (30) the error parameter (25) associated to the confidence interval (23) which comprises the confidence value (22).

10. The method of claim 9, wherein said error parameter (25) is determined during a preprocessing phase aiming to:
- run the sensor (20) over a set of reference data (51) to collect a plurality of confidence values (22),
- separate said reference data (51) into subsets depending on said confidence values (22),
- compare, for each subset, the noisy observation data (21) provided by the detector (20) with the related reference data (51), and
- compute an error covariance and the precision (P) of the detector (20) as data forming said error parameter (25).

11. A method for automatically determining and using noise statistics (30) of noisy observation data (21) provided by at least one sensor (20) connected to a tracker (100), in order to improve tracking of a time-varying object (40) across a scene using a Kalman algorithm (10), said Kalman algorithm (10) allowing to get an estimation (14) of dynamic parameters of the object (40) and providing a precision (15) of said estimation (14) from said noisy observation data (21) and from a corrected previous estimation (13'), the method comprising:
- receiving reference data (51) from a data source (50) external to the Kalman algorithm (10) and connected to the tracker (100),
- deriving, from said reference data (51), said noise statistics (30) reflecting errors made by the sensor (20), and
- using said noise statistics (30) as setting parameters of the Kalman algorithm (10), the method being **characterized by**
said sensor (2) reporting a confidence value (22) quantifying a probability that noisy observation data (21) is correct or accurate, and the method further comprises:
- using a regression model, which establishes a relationship between an error and the confidence value (22) for determining the error corresponding to the reported confidence value (22),
- including in said noise statistics (30) the error provided by the regression model for the reported confidence value (22).

12. The method of claim 11, wherein the regression model is determined on the basis of a scatter plot obtained from a plurality of detections of the object (40) by the sensor (20), wherein each point of the scatter plot is derived from a confidence value (22) and an error determined at each detection.

13. A non-transitory computer-readable medium (60) comprising program instructions for causing a processor (102) to execute the method according to any of claims 1 to 12.

14. A tracker (100) for implementing the method according to any of claims 1 to 12, comprising:
- a processing unit (102) for storing and running the Kalman algorithm (10) and steps of said method,
- a first communication interface (104) for connecting at least one sensor (20) providing noisy observation data (21), and
- a second communication interface (105) for receiving reference data (51) from an external data source (50).

## Patentansprüche

1. Verfahren für das automatische Bestimmen und Nutzen einer Rauschstatistik (30) verrauschter Beobachtungsdaten (21), die durch mindestens einen mit einem Tracker (100) verbundenen Sensor (20) bereitgestellt werden, um das Verfolgen eines zeitlich veränderlichen Objekts (40) in einer Szene unter Verwendung eines Kalman-Algorithmus (10) zu verbessern, wobei der Kalman-Algorithmus (10) eine Schätzung (14) dynamischer Parameter des Objekts (40) erlaubt und eine Präzision (15) der Schätzung (14) aus den verrauschten Beobachtungsdaten (21) und aus einer korrigierten vorherigen Schätzung (13') bereitstellt, das Verfahren umfassend:
- Empfangen von Referenzdaten (51) von einer Datenquelle (50), die außerhalb des Kalman-Algorithmus (10) liegt und mit dem Tracker (100) verbunden ist,
- Ableiten aus den Referenzdaten (51) der Rauschstatistik (30), die Fehler widerspiegelt, die von dem Sensor (20) gemacht wurden, und
- Verwenden der Rauschstatistik (30) als Einstellparameter des Kalman-Algorithmus (10), das Verfahren **dadurch gekennzeichnet, dass** der Sensor (2) einen Konfidenzwert (22) meldet, der in Beziehung zu einer Wahrscheinlichkeit steht, dass verrauschte Beobachtungsdaten (21) korrekt oder präzise sind, und das Verfahren ferner umfassend:
- Verwenden des Konfidenzwerts (22) als Gewichtungsparameter, der auf die verrauschten Beobachtungsdaten (21) über ein Beobachtungsrauschen, das ferner in den Kalman-Algorithmus (10) eingegeben wird, angewendet wird.

2. Verfahren nach Anspruch 1, wobei sich die Referenzdaten (51) auf die Szene beziehen, von der die verrauschten Beobachtungsdaten (21) über den Sensor (20) erfasst wurden, und wobei das Ableiten der Rauschstatistik (30) aus den Referenzdaten (51) durch Vergleichen der Referenzdaten (51) mit den verrauschten Beobachtungsdaten (21) erreicht wird, die von dem Sensor (20) bereitgestellt werden.

3. Verfahren nach Anspruch 2, wobei die Referenzdaten (51) das Aufzeichnen der von der Datenquelle (50) empfangenen Beobachtungsdaten umfasst, und die Referenzdaten (51) verwendet werden, um den Tracker (100) zu kalibrieren.

4. Verfahren nach einem der Ansprüche 1 oder 3, wobei die Rauschstatistik (30) eine Präzision (P) des Sensors (20) umfasst, die die Wahrscheinlichkeit definiert, dass die verrauschten Beobachtungsdaten (21) korrekt sind.

5. Verfahren nach Anspruch 4, wobei die Präzision (P) des Sensors (20) verwendet wird, um zu bestimmen, ob die zugehörigen verrauschten Beobachtungsdaten (21), die von dem Sensor (20) bereitgestellt werden, von dem Tracker (100) berücksichtigt werden müssen, um das Objekt (40) zu verfolgen, oder verworfen werden müssen.

6. Verfahren nach einem der Ansprüche 1 bis 5, wobei sich die verrauschten Beobachtungsdaten (21) auf eine Vielzahl von Messvariablen (41) des Objekts (40) beziehen, von der mindestens ein Paar der Messvariablen (41) identifizierbar ist und die Rauschstatistik (30) mindestens eines aus Folgendem umfasst:
- Eine erwartete Varianz jeder der Messvariablen (41), und
- eine erwartete Kovarianz jeder der Messvariablen (41).

7. Verfahren nach Anspruch 6, wobei sich die Messvariablen (41) auf mindestens eines aus Folgendem beziehen:
- Maßdaten des Objekts (40),
- Positionsdaten des Objekts (40) innerhalb der Szene,
- Abstandsdaten zwischen dem Objekt (40) und dem Sensor (20), und
- absolute oder relative Geschwindigkeitsdaten des Objekts (40), und
- absolute oder relative Beschleunigungsdaten des Objekts (40).

8. Verfahren nach Anspruch 6 oder 7, wobei die erwartete Kovarianz zwischen jedem Paar von Messvariablen (41) in einer Kovarianzmatrix (vₖ) oder Vektorform bereitgestellt und als Eingabe in den Kalman-Algorithmus (10) verwendet wird, um ein Beobachtungsrauschen der verrauschten Beobachtungsdaten (21) zu definieren.

9. Verfahren für das automatische Bestimmen und Nutzen einer Rauschstatistik (30) verrauschter Beobachtungsdaten (21), die durch mindestens einen mit einem Tracker (100) verbundenen Sensor (20) bereitgestellt werden, um das Verfolgen eines zeitlich veränderlichen Objekts (40) in einer Szene unter Verwendung eines Kalman-Algorithmus (10) zu verbessern, wobei der Kalman-Algorithmus (10) eine Schätzung (14) dynamischer Parameter des Objekts (40) erlaubt und eine Präzision (15) der Schätzung (14) aus den verrauschten Beobachtungsdaten (21) und aus einer korrigierten vorherigen Schätzung (13') bereitstellt, das Verfahren umfassend:
- Empfangen von Referenzdaten (51) von einer Datenquelle (50), die außerhalb des Kalman-Algorithmus (10) liegt und mit dem Tracker (100) verbunden ist,
- Ableiten aus den Referenzdaten (51) der Rauschstatistik (30), die Fehler widerspiegelt, die von dem Sensor (20) gemacht wurden, und
- Verwenden der Rauschstatistik (30) als Einstellparameter des Kalman-Algorithmus (10), das Verfahren **gekennzeichnet dadurch, dass** die Rauschstatistik (30) eine Präzision (P) des Sensors (20) umfasst, die die Wahrscheinlichkeit definiert, dass die verrauschten Beobachtungsdaten (21) korrekt sind, und wobei der Sensor (20) einen Konfidenzwert (22) meldet, der in Beziehung zu einer Wahrscheinlichkeit steht, dass verrauschte Beobachtungsdaten (21) korrekt oder präzise sind, und das Verfahren ferner umfassend:
- Vergleichen des Konfidenzwerts (22) mit einer Vielzahl vorbestimmter Konfidenzintervalle (23), mit denen jeweils ein Fehlerparameter (25) verbunden ist, und
- Einschließen in die Rauschstatistik (30) des Fehlerparameters (25), der mit dem Konfidenzintervall (23) verbunden ist, das den Konfidenzwert (22) umfasst.

10. Verfahren nach Anspruch 9, wobei der Fehlerparameter (25) während einer Vorverarbeitungsphase bestimmt wird, die auf Folgendes abzielt:
- Ausführen des Sensors (20) an einem Satz von Referenzdaten (51), um eine Vielzahl von Konfidenzwerten (22) zu erfassen,
- Trennen der Referenzdaten (51) in Teilsätze, die von den Konfidenzwerten (22) abhängen,
- Vergleichen, für jeden Teilsatz, der verrauschten Beobachtungdaten (21), die von dem Detektor (20) bereitgestellt werden, mit den zugehörigen Referenzdaten (51), und
- Berechnen einer Fehler-Kovarianz und der Präzision (P) des Detektors (20) als Daten, die den Fehlerparameter (25) bilden.

11. Verfahren für das automatische Bestimmen und Nutzen einer Rauschstatistik (30) verrauschter Beobachtungsdaten (21), die durch mindestens einen mit einem Tracker (100) verbundenen Sensor (20) bereitgestellt werden, um das Verfolgen eines zeitlich veränderlichen Objekts (40) in einer Szene unter Verwendung eines Kalman-Algorithmus (10) zu verbessern, wobei der Kalman-Algorithmus (10) eine Schätzung (14) dynamischer Parameter des Objekts (40) erlaubt und eine Präzision (15) der Schätzung (14) aus den verrauschten Beobachtungsdaten (21) und aus einer korrigierten vorherigen Schätzung (13') bereitstellt, das Verfahren umfassend:
- Empfangen von Referenzdaten (51) von einer Datenquelle (50), die außerhalb des Kalman-Algorithmus (10) liegt und mit dem Tracker (100) verbunden ist,
- Ableiten aus den Referenzdaten (51) der Rauschstatistik (30), die Fehler widerspiegelt, die von dem Sensor (20) gemacht wurden, und
- Verwenden der Rauschstatistik (30) als Einstellparameter des Kalman-Algorithmus (10), das Verfahren **dadurch gekennzeichnet, dass** der Sensor (2) einen Konfidenzwert (22) meldet, der eine Wahrscheinlichkeit quantifiziert, dass verrauschte Beobachtungsdaten (21) korrekt oder präzise sind, und das Verfahren ferner umfassend:
- Verwenden eines Regressionsmodells, das eine Beziehung zwischen einem Fehler und dem Konfidenzwert (22) festlegt, um den Fehler zu bestimmen, der dem gemeldeten Konfidenzwert (22) entspricht,
- wobei in die Rauschstatistik (30) der Fehler eingeschlossen ist, der durch das Regressionsmodell für den gemeldeten Konfidenzwert (22) bereitgestellt wurde.

12. Verfahren nach Anspruch 11, wobei das Regressionsmodell auf der Grundlage eines Scatterplots bestimmt wird, der von einer Vielzahl von Detektionen des Objekts (40) durch den Sensor (20) erlangt wird, wobei jeder Punkt des Scatterplots aus einem Konfidenzwert (22) und einem Fehler, der an der jeweiligen Detektion bestimmt wird, abgeleitet wird.

13. Ein nichtflüchtiges computerlesbares Medium (60), das Programmanweisungen umfasst, um einen Prozessor (102) zu veranlassen, das Verfahren nach einem der Ansprüche 1 bis 12 auszuführen.

14. Ein Tracker (100) für das Implementieren des Verfahrens nach einem der Ansprüche 1 bis 12, umfassend:
- Eine Verarbeitungseinheit (102) für das Speichern und Ausführen des Kalman-Algorithmus (10) und der Schritte des Verfahrens,
- eine erste Kommunikationsschnittstelle (104) für das Verbinden mindestens eines Sensors (20), der verrauschte Beobachtungsdaten (21) bereitstellt, und
- eine zweite Kommunikationsschnittstelle (105) für das Empfangen von Referenzdaten (51) von einer externen Datenquelle (50).

## Revendications

1. Procédé destiné à la détermination et à l'utilisation automatiques de statistiques de bruit (30) de données d'observation bruitées (21) fournies par au moins un capteur (20) connecté à un suiveur (100), afin d'améliorer le suivi d'un objet variant dans le temps (40) sur toute l'étendue d'une scène à l'aide d'un algorithme de Kalman (10), ledit algorithme de Kalman (10) permettant d'obtenir une estimation (14) des paramètres dynamiques de l'objet (40) et fournissant une précision (15) de ladite estimation (14) à partir desdites données d'observation bruitées (21) et à partir d'une estimation précédente corrigée (13'), le procédé comprenant :
- la réception des données de référence (51) en provenance d'une source de données (50) externe à l'algorithme de Kalman (10) et connectée au suiveur (100),
- la dérivation, à partir desdites données de référence (51), desdites statistiques de bruit (30) reflétant les erreurs commises par le capteur (20), et
- l'utilisation desdites statistiques de bruit (30) comme paramètres de réglage de l'algorithme de Kalman (10), le procédé étant **caractérisé en ce que** ledit capteur (2) rapporte une valeur de confiance (22) qui est en relation avec une probabilité que des données d'observation bruitées (21) soient correctes ou précises, et le procédé comprend en outre :
- l'utilisation de ladite valeur de confiance (22) comme paramètre de pondération appliqué auxdites données d'observation bruitées (21) par l'intermédiaire d'un bruit d'observation entré en outre dans l'algorithme de Kalman (10).

2. Procédé selon la revendication 1, dans lequel lesdites données de référence (51) se rapportent à la scène à partir de laquelle les données d'observation bruitées (21) ont été obtenues à travers le capteur (20), et dans lequel la dérivation des statistiques de bruit (30) à partir des données de référence (51) est obtenue en comparant lesdites données de référence (51) avec les données d'observation bruitées (21) fournies par le capteur (20).

3. Procédé selon la revendication 2, dans lequel lesdites données de référence (51) comprennent des données d'observation annotées reçues en provenance de la source de données (50) et lesdites données de référence (51) sont utilisées pour étalonner le suiveur (100).

4. Procédé selon l'une quelconque des revendications 1 ou 3, dans lequel lesdites statistiques de bruit (30) comprennent une précision (P) du capteur (20) qui définit la probabilité que les données d'observation bruitées (21) soient correctes.

5. Procédé selon la revendication 4, dans lequel la précision (P) du capteur (20) est utilisée pour déterminer si les données d'observation bruitées associées (21) fournies par ledit capteur (20) doivent être prises en compte par le suiveur (100) destiné à suivre ledit objet (40) ou doivent être éliminées.

6. Procédé selon l'une quelconque des revendications 1 à 5, dans lequel lesdites données d'observation bruitées (21) concernent une pluralité de variables mesurées (41) de l'objet (40) à partir desquelles au moins une paire de variables mesurées (41) est identifiable et lesdites statistiques de bruit (30) comprennent au moins l'un des éléments parmi :
- une variance attendue de chacune des variables mesurées (41), et
- une covariance attendue entre chaque paire de variables mesurées (41).

7. Procédé selon la revendication 6, dans lequel les variables mesurées (41) se rapporte à au moins l'un des éléments parmi :
- les données dimensionnelles de l'objet (40),
- les données de positionnement de l'objet (40) à l'intérieur de la scène,
- les données de distance entre l'objet (40) et le capteur (20), et
- des données de vitesse absolue ou relative de l'objet (40), et
- des données d'accélération absolue ou relative de l'objet (40).

8. Procédé selon la revendication 6 ou 7, dans lequel la covariance attendue entre chaque paire de variables mesurées (41) est située dans une matrice de covariance (vₖ) ou sous forme vectorielle et est utilisée comme entrée de l'algorithme de Kalman (10) pour définir un bruit d'observation des données d'observation bruitées (21).

9. Procédé destiné à la détermination et à l'utilisation automatiques de statistiques de bruit (30) de données d'observation bruitées (21) fournies par au moins un capteur (20) connecté à un suiveur (100), afin d'améliorer le suivi d'un objet variant dans le temps (40) sur toute l'étendue d'une scène à l'aide d'un algorithme de Kalman (10), ledit algorithme de Kalman (10) permettant d'obtenir une estimation (14) des paramètres dynamiques de l'objet (40) et fournissant une précision (15) de ladite estimation (14) à partir desdites données d'observation bruitées (21) et à partir d'une estimation précédente corrigée (13'), le procédé comprenant :
- la réception des données de référence (51) en provenance d'une source de données (50) externe à l'algorithme de Kalman (10) et connectée au suiveur (100),
- la dérivation, à partir desdites données de référence (51), desdites statistiques de bruit (30) reflétant les erreurs commises par le capteur (20), et
- l'utilisation desdites statistiques de bruit (30) comme paramètres de réglage de l'algorithme de Kalman (10), le procédé étant **caractérisé en ce que** lesdites statistiques de bruit (30) comprenant une précision (P) du capteur (20) qui définit la probabilité que les données d'observation bruitées (21) soient correctes et dans lequel ledit capteur (20) rapporte une valeur de confiance (22), qui est en relation avec une probabilité que les données d'observation bruitées (21) soient correctes ou précises et le procédé comprend en outre :
- la comparaison de ladite valeur de confiance (22) à une pluralité d'intervalles de confiance prédéfinis (23) auxquels un paramètre d'erreur (25) est associé, et
- l'inclusion dans lesdites statistiques de bruit (30) du paramètre d'erreur (25) associé à l'intervalle de confiance (23) qui comprend la valeur de confiance (22).

10. Procédé selon la revendication 9, dans lequel ledit paramètre d'erreur (25) est déterminé pendant une phase de prétraitement visant à :
- faire fonctionner le capteur (20) sur un ensemble de données de référence (51) pour collecter une pluralité de valeurs de confiance (22),
- séparer lesdites données de référence (51) en sous-ensembles en fonction desdites valeurs de confiance (22),
- comparer, pour chaque sous-ensemble, les données d'observation bruitées (21) fournies par le détecteur (20) avec les données de référence associées (51), et
- calculer une covariance d'erreur et la précision (P) du détecteur (20) comme données formant ledit paramètre d'erreur (25).

11. Procédé destiné à la détermination et à l'utilisation automatiques de statistiques de bruit (30) de données d'observation bruitées (21) fournies par au moins un capteur (20) connecté à un suiveur (100), afin d'améliorer le suivi d'un objet variant dans le temps (40) sur toute l'étendue d'une scène à l'aide d'un algorithme de Kalman (10), ledit algorithme de Kalman (10) permettant d'obtenir une estimation (14) des paramètres dynamiques de l'objet (40) et fournissant une précision (15) de ladite estimation (14) à partir desdites données d'observation bruitées (21) et à partir d'une estimation précédente corrigée (13'), le procédé comprenant :
- la réception des données de référence (51) en provenance d'une source de données (50) externe à l'algorithme de Kalman (10) et connectée au suiveur (100),
- la dérivation, à partir desdites données de référence (51), desdites statistiques de bruit (30) reflétant les erreurs commises par le capteur (20), et
- l'utilisation desdites statistiques de bruit (30) comme paramètres de réglage de l'algorithme de Kalman (10), le procédé étant **caractérisé en ce que** ledit capteur (2) rapporte une valeur de confiance (22) quantifiant une probabilité que des données d'observation bruitées (21) soient correctes ou précises, et le procédé comprend en outre :
- l'utilisation d'un modèle de régression, qui établit une relation entre une erreur et la valeur de confiance (22) destinée à la détermination de l'erreur correspondant à la valeur de confiance rapportée (22),
- l'inclusion dans lesdites statistiques de bruit (30) de l'erreur fournie par le modèle de régression pour la valeur de confiance rapportée (22).

12. Procédé selon la revendication 11, dans lequel le modèle de régression est déterminé en fonction d'un diagramme de dispersion obtenu à partir d'une pluralité de détections de l'objet (40) par le capteur (20), dans lequel chaque point du diagramme de dispersion étant dérivé d'une valeur de confiance (22) et d'une erreur déterminée à chaque détection.

13. Support lisible par ordinateur non transitoire (60) comprenant des instructions de programme destinées à amener un processeur (102) à exécuter le procédé selon l'une quelconque des revendications 1 à 12.

14. Suiveur (100) destiné à mettre en œuvre le procédé selon l'une quelconque des revendications 1 à 12, comprenant :
- une unité de traitement (102) destinée à mémoriser et à exécuter l'algorithme de Kalman (10) et les étapes dudit procédé,
- une première interface de communication (104) destinée à connecter au moins un capteur (20) fournissant des données d'observation bruitées (21), et
- une seconde interface de communication (105) destinée à recevoir des données de référence (51) en provenance d'une source de données externe (50).
